# EUROPEAN PATENT APPLICATION

(11) **EP 2 833 195 A1**
(43) Date of publication of application: **04.02.2015**
(21) Application number: 13275173.6
(22) Date of filing: 29.07.2013
(51) Int. Cl.: G02B 27/10, H01S 3/23, G02B 19/00

(54) **Apparatus for Aligning Radiation Beams**

(71) Applicant: BAE Systems PLC, London SW1Y 5AD (GB)
(72) Inventor: The designation of the inventor has not yet been filed
(74) Representative: BAE SYSTEMS plc Group IP Department

(57) **Abstract**

Apparatus for co-aligning a plurality of laterally displaced radiation beams, each beam comprising a respective waveband, is disclosed. The apparatus comprises a collimating element for receiving each of said radiation beams with respective lateral displacements and a combining element for receiving each of said radiation beams passed by said collimating element to cause the radiation beams to become co-aligned. At least one of the collimating element and the combining element comprises an anti-reflection layer for minimising reflection of the radiation beams from the at least one element. The layer comprises an array of microstructured protuberances which extend away from at least a portion of a surface of the respective element, and which comprise a crosssectional area which reduces along the length thereof, from a proximal end of the protuberance disposed proximate the surface to a distal end of the protuberance.

## Description

The present invention relates to an apparatus for aligning radiation beams, more specifically, co-aligning a plurality of laterally displaced radiation beams and particularly, but not exclusively, to apparatus for handling multiple laser beams over extended wavelength ranges.

There is often a need to combine and co-align lasers beams at different wavelengths, such as in remote spectroscopy and optical communication. The traditional way of combining and co-aligning laser beams utilises a spectral beam combiner (SBC). In this approach, the radiation from a number of spatially separated laser sources is collected and collimated by a common optic, such as a lens, which translates spatial separation in the lens focal plane (i.e., at the laser sources) into angular separation in the image plane. A diffractive optical element (DOE), such as a prism, is then placed following the lens, upon which the different wavelength beams are incident at different angles. The prism is arranged to refract the angularly separated beams from the lens, caused by the spatial separation of the laser beams, and combine the laser beams so that they become co-aligned.

The angular separation of the laser beams incident upon the diffractive optical element is dependent on the lateral separation of the laser beams from the optical axis of the lens and the wavelength of the laser beam. Accordingly, the lateral separation and wavelength are typically selected for a specific lens and diffractive optical element arrangement, so that the beams passed from the diffractive optical element become combined and co-aligned.

It is found that in order to operate across a very broad spectral band, for example ultraviolet to mid-infrared, only a limited choice of materials are available to fabricate the optical elements. Traditionally, for such a spectral band, sapphire and calcium fluoride may be used since these materials have a high refractive index and high dispersion. However, the Fresnel reflections at the air/optical element interface at normal incidence ranges from 6% at 4.5µm wavelength to 8% at 300nm wavelength, and since a SBC will comprise at least four interfaces, this equates to a loss of at least 24% of the original laser beam power at the output, through reflection alone.

Accordingly, SBCs typically incorporate anti-reflection coatings on the surface of the optical elements to minimise reflected laser power losses. The problem however, is that conventional anti-reflection coatings are based on dielectric thin films, the thickness of which is tailored to reduce reflections over a narrow range of laser wavelengths. Therefore, it is clear that these anti-reflection coatings are insufficient to reduce reflection losses when the SBC is arranged to combine laser beams operating over an extended wavelength range.

In accordance with a first aspect of the present invention, there is provided an apparatus for co-aligning laterally displaced radiation beams, each beam comprising a respective waveband, the apparatus comprising:
a collimating element for receiving each of said radiation beams with respective lateral displacements; and
a combining element for receiving each of said radiation beams passed by said collimating element to cause the radiation beams to become co-aligned;
wherein at least one of the collimating element and the combining element comprise an anti-reflection layer for minimising reflection of the radiation beams from the at least one element, the layer comprising an array of microstructured protuberances which extend away from at least a portion of a surface of the respective element, the protuberances having a cross-sectional area which reduces along the length thereof, from a proximal end of the protuberance disposed proximate the surface to a distal end of the protuberance.

Advantageously, the variation in cross-sectional area of the protuberances creates a gradually varying effective refractive index over the thickness of the layer which minimises the Fresnel reflections and offers an anti-reflection function over an extended spectral width. The protuberances of the layer are formed sufficiently small that radiation beams are unable to resolve them and as a result, the radiation beams experience an effective refractive index rather than small protuberances of glass, for example, separated by air.

The layer is formed of the same material as the element upon which it is disposed and comprises a surface modification of the element. The layer is thus preferably formed integrally with the element and in an embodiment, the layer is produced by impressing a pattern onto the surface of the element photolithographically and subsequently etching the surface of the element to selectively remove the areas which have/have not been exposed during the photolithographic process. However, with elements formed of a softer glass, the layer may alternatively be applied by using a hot press technique.

The protuberances of the array are conveniently configured to a substantially hexagonal grid and in an embodiment, the protuberances are separated by a distance less than the shortest radiation beam wavelength used in the apparatus, divided by the refractive index of the at least one optical element to which the layer is applied. The protuberances comprise a height which is preferably substantially equal to or greater than the longest radiation beam wavelength, and preferably comprise a truncated cone shape.

In an embodiment, the collimating element comprises an achromatic doublet lens, such as a combination meniscus lens and biconvex lens, and the combining element comprises a prism, such as a wedge prism.

In accordance with the present invention as seen from a second aspect, there is provided a method of co-aligning a plurality of laterally displaced radiation beams, each beam comprising a respective waveband, the method comprising the use of the apparatus of the first aspect.

Embodiments of the present invention will now be described by way of example only and with reference to the accompanying drawings, in which:
Figure 1 is schematic illustration of the apparatus for co-aligning a plurality of laterally displaced radiation beams according to an embodiment of the present invention; and,
Figure 2a is a schematic illustration of a side view of a portion of an anti-reflection layer disposed upon the optical elements illustrated in figure 1; and,
Figure 2b is a schematic illustration of a plan view of a portion of an anti-reflection layer disposed upon the optical elements illustrated in figure 1.

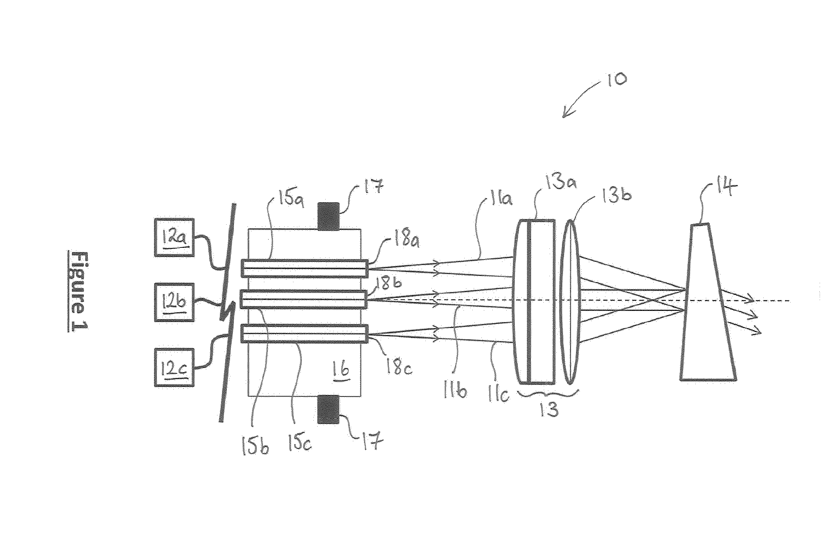

Referring to figure 1 of the drawings, there is illustrated a schematic illustration of an apparatus 10 for co-aligning radiation beams, such as laser radiation beams 11a-c output from respective radiation sources 12a-c, according to an embodiment of the present invention. The apparatus 10 comprises a collimator element 13, such as a lens or lens arrangement, which is arranged to receive the radiation beams 11a-c from the radiation sources 12a-c, and a combining element 14, such as a prism, for combining the collimated beams incident thereon from the collimator element 13.

The radiation output from the radiation sources 12a-c is coupled into a proximal end of a respective waveguide 15a-c, such as an optical fibre, and guided to a waveguide mount 16, to which the distal end of the waveguide is secured. The mount 16 is disposed upon a translation stage 17 which permits controlled movement of the waveguides 15a-c disposed thereon. In particular, the stage 17 enables controlled movements of the waveguides 15a-c in the three orthogonal directions, namely *x*, *y*, and *z* directions and also controlled rotational movements to vary the pitch, roll and yaw movements of the waveguides 15a-c so that outputs 18a-c of the waveguides 15a-c can be suitably positioned and orientated relative to the lens 13.

In the embodiment illustrated the lens 13 comprises an achromatic doublet lens and the prism 14 comprises a wedge prism. The doublet comprises a meniscus lens 13a and a biconvex lens 13b mounted in close proximity to each other or possibly cemented together and is arranged to minimise any defocussing of the laser beams 11a-c incident thereon due to the different operative wavebands of the laser beams.

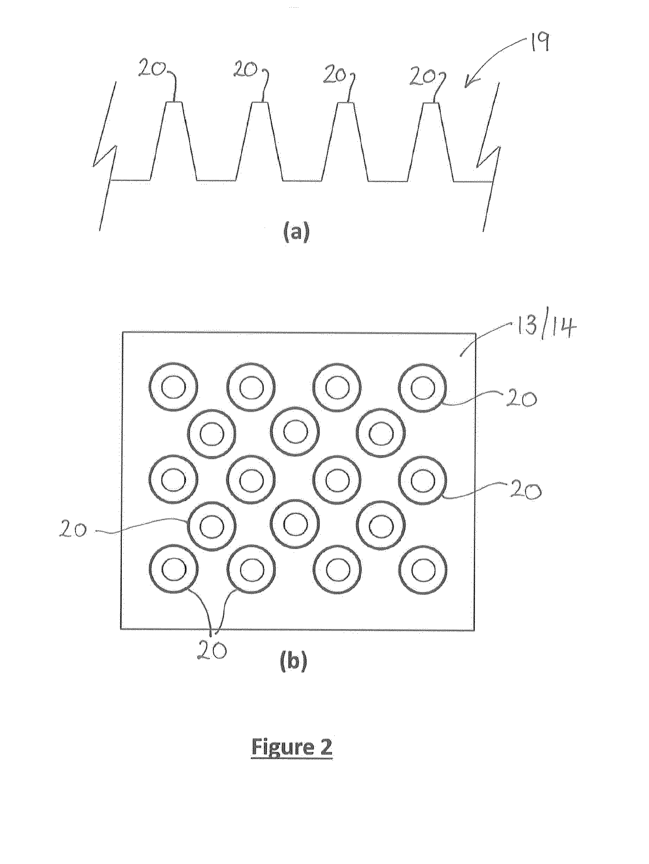

The lens 13 and prism 14 in the illustrated embodiment separately comprise an anti-reflection layer 19 disposed upon at least the portion of the surfaces illuminated by the laser beams. Referring to figure 2a and 2b of the drawings, the anti-reflection layer 19 comprises a microstructured array of protuberances 20 which may be formed on the surface of the lens 13 and prism 14 via lithographic and/or etching techniques, for example.

In an embodiment, the protuberances 20 are configured to a hexagonal array, however, it is to be appreciated that the protuberances 20 may be configured to an alternatively shaped array, such as a square array. The protuberances 20 are separated by a distance which is less than the shortest laser beam wavelength used in the apparatus 10, divided by the refractive index of the element 13, 14 upon which they are disposed. In this respect, the radiation beams 11a-c are unable to resolve the protuberances 20 and thus do not become diffracted when interacting with the layer 19.

The height of the protuberances 20 is substantially equal to or greater than the longest laser beam wavelength used in the apparatus 10 and comprise a cross-sectional area which reduces along the length of the protuberances 20 away from the surface of the lens 13 and/or prism 14. In an embodiment, the protuberances 20 may comprise a substantially truncated cone shape, however, other shapes are also envisaged, such as truncated pyramidal and tetrahedral shapes.

The protuberances 20 of the layer 19 effectively provide a continuous refractive index gradient between the surrounding air and the optical element 13, 14 and thus provide an improved reduction in reflection of the laser beams 11a-c by removing the sharp discontinuity that is otherwise provided with uncoated optics. Moreover, the microstructured anti-reflection layer 19 offers an anti-reflection functionality over the extended wavelength range of the laser beams 11a-c and thus an increased combined laser beam power output from the apparatus, compared with conventional spectral beam combining apparatus.

## Claims

1. Apparatus for co-aligning laterally displaced radiation beams, each beam comprising a respective waveband, the apparatus comprising:
a collimating element for receiving each of said radiation beams with respective lateral displacements; and
a combining element for receiving each of said radiation beams passed by said collimating element to cause the radiation beams to become co-aligned;
wherein at least one of the collimating element and the combining element comprises an anti-reflection layer for minimising reflection of the radiation beams from the at least one element, the layer comprising an array of microstructured protuberances which extend away from at least a portion of a surface of the respective element, the protuberances having a cross-sectional area which reduces along the length thereof, from a proximal end of the protuberance disposed proximate the surface to a distal end of the protuberance.

2. Apparatus according to claim 1, wherein the protuberances of the array are to a substantially hexagonal array.

3. Apparatus according to claim 1 or 2, wherein the protuberances are separated by a distance less than the shortest laser beam wavelength used in the apparatus, divided by the refractive index of the at least one optical element to which the layer is applied.

4. Apparatus according to any preceding claim, wherein the protuberances are of a height which is substantially equal to or greater than the longest laser beam wavelength.

5. Apparatus according to any preceding claim, wherein the collimating element comprises an achromatic doublet lens.

6. Apparatus according to any preceding claim, wherein the combining element comprises a prism.

7. A method of co-aligning laterally displaced radiation beams, each beam comprising a respective waveband, the method comprising use of the apparatus according to any preceding claim.
